Europäisches Patentamt

European Patent Office

Office européen des brevets

(11) Veröffentlichungsnummer: **0 324 189**
**A2**

## (12) EUROPÄISCHE PATENTANMELDUNG

(21) Anmeldenummer: 88121921.6

(22) Anmeldetag: 31.12.88

(51) Int. Cl.⁴: **H05K 3/38 , H05K 3/18**

(30) Priorität: 13.01.88 DE 3800682

(43) Veröffentlichungstag der Anmeldung:
19.07.89 Patentblatt 89/29

(84) Benannte Vertragsstaaten:
**AT BE CH DE FR GB IT LI NL SE**

(71) Anmelder: **BAYER AG**

**D-5090 Leverkusen 1 Bayerwerk(DE)**

(72) Erfinder: **Wolf, Gerhard Dieter, Dr.**
**Wilhelm-Busch-Strasse 29**
**D-4047 Dormagen 5(DE)**
Erfinder: **Sirinyan, Kirkor, Dr.**
**Humperdinckstrasse 12**
**D-5060 Bergisch-Gladbach 2(DE)**
Erfinder: **von Gizycki, Ulrich, Dr.**
**Wiembachallee 23**
**D-5090 Leverkusen 3(DE)**
Erfinder: **Merten, Rudolf, Dr.**
**Berta-von-Suttner-Strasse 55**
**D-5090 Leverkusen 1(DE)**
Erfinder: **Langer, Friedrich**
**An der Wasserdelle 17**
**D-5060 Bergisch-Gladbach 1(DE)**

(54) **Verfahren zur Herstellung von elektrischen Leiterplatten.**

(57) Leiterplatten mit gut haftenden Leiterbahnen erhält man, wenn man die Basisplatten, die beidseitig
mit Kupferfolien kaschiert sind, chemisch oder mechanisch von dieser Kaschierung befreit, aktiviert,
gegebenenfalls sensibilisiert, in einem stromlosen
Metallisierungsbad mit einer 0,05 -2,0 μm starken
Schicht aus Nickel, Kobalt, Mangan, einem
Nickel/Eisen-oder Nickel/ Kobalt-Gemisch versieht, in
einem darauffolgenden Kupferbad eine 0,5-5,0 μm
dicke Kupferschicht aufbringt und darauf nach üblichen Semiadditivmethoden das Leiterbild aufbaut.

EP 0 324 189 A2

## Verfahren zur Herstellung von elektrischen Leiterplatten

Gegenstand der Erfindung sind ein Verfahren zur Herstellung von qualitativ hochwertigen Leiterplatten sowie die so hergestellten Leiterplatten und deren Verwendung zur Herstellung von gedruckten Schaltungen.

Es ist allgemein bekannt, daß man zur Herstellung von elektrischen Leiterplatten in metallkaschierten oder metallaminierten Isolierbasismaterialien Bohrungen anbringt, die Substratoberfläche mit einer Maske bedeckt, die freie Metalloberfläche auf galvanischem Wege mit einem ätzmittelbeständigen Metallresist versieht, die Maske in einem geeigneten Medium von der Substratoberfläche entfernt und dann die Grundmetallschicht wegätzt. Die zur Durchführung dieses Verfahrens (Subtraktiv-Verfahren) eingesetzten Metallauflagen bestehen in den meisten Fällen aus reinem Elektrolytkupfer und haben in der Regel eine Schichtdicke von 17,5 bis 70 $\mu$m.

Die bekannten Subtraktiv-Verfahren haben nicht nur den Nachteil, daß sie aus mehreren Teilschritten bestehen, sondern sie führen im letzten Schritt zur Unterätzung der Leiterbahnen.

Ein weiterer Nachteil der bekannten Verfahren besteht darin, daß sie Metallresiste erfordern.

Beim Aufbringen der Metallresistauflage kann das galvanisch aufwachsende Metallresist auch seitlich "auswuchern". Man spricht von "Überplattierung" oder auch "Pilzbildung" der Leiterbahnen, was sich auf die im Querschnitt zu sehende pilzähnliche Form und die geringe Tiefenschärfe bezieht. Dieser unerwünschte Effekt wird durch das nachfolgende Wegätzen der Grundkupferschicht noch weiter verstärkt. Um die besagte "Überplattierung" oder "Pilzbildung" zu vermeiden, müssen mechanisch stabile und dicke Folienresists verwendet werden.

Solche mechanisch stabilen Folienreste sollen sowohl die Kupferleiter als auch das Resistmetall "kanalisieren" und somit die Pilzbildung vermeiden.

Ein weiterer sehr großer Nachteil der Metallresiste besteht darin, daß sie beim Löten schmelzen und zum bekannten Apfelsinenhauteffekt führen. Besonders bei hochwertigen Leiterplatten kann dieser Effekt nicht akzeptiert werden.

Als besonderer Nachteil des Subtraktiv-Verfahrens sei erwähnt, daß es zur Herstellung von Feinleiterplatten mit einer Leiterbahnbreite von unter 200 $\mu$m aus den genannten Gründen nicht geeignet ist.

Um die angegebenen Nachteile zu vermeiden, wurde bereits versucht, die sogenannten Semiadditiv- und Volladditiv-Verfahren zu entwickeln. Zur Durchführung dieser Verfahren ist das Aufbringen einer dünnen, gut haftenden, lötbadstabilen, elektrisch-leitfähigen Metallauflage von größter Wichtigkeit.

Es ist weiterhin bekannt, daß die direkte Abscheidung von haftfesten relativ dünnen Metallauflagen ($\leq$ 5 $\mu$m) auf den üblichen Isolierbasismaterialien eine aufwendige Vorbehandlung erfordert. So müssen beispielsweise die Basisplatten aus glasmattenverstärkten Epoxidharzen oder papierverstärkten Phenolharzen zur Herstellung von Leiterplatten zunächst mit einer Haftvermittlerschicht versehen und anschließend mit einer oxidierenden Flüssigkeit, vorzugsweise Chromschwefelsäure, behandelt werden, bevor die so präparierten Platten mit ionischen oder kolloidalen Edelmetallösungen aktiviert, maskiert und in handelsüblichen Metallisierungsbädern metallisiert werden.

Abgesehen von der Vielstufigkeit dieser Methoden weist diese Technik den Nachteil auf, daß eingeschleppte Chromionen die Bäder irreversibel vergiften und daß die erhaltenen Leiterplatten unbefriedigende elektrische Eigenschaften zeigen.

Es ist daher bereits vorgeschlagen worden, die nichtleitenden Oberflächen von Substraten, beispielsweise Basisträger von Leiterplatten, ohne oxidative Vorbehandlung mit einer Lösung oder einem Lack einer Edelmetallaminkomplexbildung bzw. des Palladiumchlorids für die anschließende chemische Metallisierung zu aktivieren (vgl. z. B. DE-A 1 696 603 und DE-A 2 116 389, entsprechend. US-A 2 560 257 bzw. US-A 248 632).

Diese an sich materialschonenden Aktivierungsverfahren konnten sich jedoch bislang in der Praxis nich durchsetzen, da sie verhältnismäßig große Edelmetallmengen benötigen und die in der Elektronikindustrie geforderten hohen Abzugsfestigkeiten der Metallauflagen nich erreichen. Aus diesem Grunde wird zumindest in der erstgenannten Patentpublikation eine zusätzliche Oberflächenbehandlung mit Ätzmittel empfohlen (vgl. Spalte 6, Zeile 48).

Schließlich ist bekannt (vgl. US 3 620 933), daß polymere Basismaterialien aus Phenol- oder Epoxidharzen, die mit einer nachträglich oxidierten Aluminiumfolie versehen sind, nach dem chemischen oder physikalischen Entfernen der Metallauflage durch übliche Semiadditiv- oder Subtraktiv-Verfahren ohne Ätzmittelanwendung zu Leiterplatten verarbeitet werden können. Dieses Verfahren weist jedoch neben diversen anderen Nachteilen den Mangel auf, zur Abscheidung von Metallauflagen mit geringer Abzugsfestigkeit zu führen. Darüber hinaus werden die elektrischen Eigenschaften, wie elektrischer Ober flächenwiderstand und Kriechstromfestigkeit, des polymeren Basismaterials durch die dünne Metalloxidschicht irreversibel verschlechtert.

Um diese Nachteile zu vermeiden ist schließlich der Vorschlag gemacht worden (vgl. DE-A 3 510 202), hochwertige elektrische Leiterplatten nach einer Semi- oder Volladditivmethode dadurch herzustellen, daß man auf Basismaterial naßchemisch unter Verwendung von organischen Edelmetallverbindungen als Aktivatoren das Leiterbild aufbringt, wobei die Oberfläche des Basismaterials durch

a) ein flächenbezogenes spezifisches Gesamtporenvolumen von 0,015 bis 0,045 dm³/m²

b) einen mittleren Porendurchmesser von 0,05 bis 12,5 µm und

c) eine mittlere Porentiefe von 0,05 bis 4,0 µm

charakterisiert ist.

Derartige Oberflächenstrukturen werden vorzugsweise dadurch erhalten, daß man solche Basismaterialien einsetzt, die mit Kupferfolien kaschiert sind, die üblichereise auf der dem Basismaterial zugewandten Seite ein spezielles Treatment enthalten. Das Treatment weist nämlich eine besondere dentritische Struktur auf, die beim Kaschieren auf den polymeren Trägerwerkstoff übertragen wird und nach dem mechanischen oder chemischen Ablösen der Kaschierung auf der Kunststoffoberfläche hinterbleibt.

Obwohl Basisplatten mit derartig präparierten Oberfläche bei Anwendung üblicher Metallisierungstechniken qualitativ hochwertige Leiterplatten ohne die oben aufgezeigten Mängel liefern, genügen sie nicht allerhöchsten Ansprüchen der Leiterplattentechnik, insbesondere nicht bei der Herstellung von Feinstleiterplatten, da in diesem Fall die Ausschußrate unverhältnismäßig hoch ist.

Es wurde nun gefunden, daß man auch diese Mängel beseitigen kann und zu einwandfreien Leiterplatten gelangt, wenn man Basisplatten, die beidseitig mit Cu-Folien kaschiert sind,

a) nach dem Zuschneiden und Bohren chemisch oder mechanisch von der Kupferkaschierung befreit,

b) die Oberflächen der Basisplatten und die Bohrlochwandungen durch Eintauchen in ein Aktivatorbad aktiviert

c) gegebenenfalls sensibilisiert,

d) in einem stromlosen Metallisierungsbad mit einer 0,05-2,0 µm starken Schicht aus Nickel, Kobalt, Mangan, einem Nickel/Eisen- oder Nickel/Kobalt-Gemisch versieht,

e) in einem darauffolgenden Kupferbad mit einer 0,5-5,0 µm starken Kupferschicht versieht und

f) darauf nach üblichen Semiadditivmethoden das Leiterbild aufbaut.

Die praktische Durchführung der einzelnen Teilschritte a) - f) erfolgt auf folgende Weise:

Bei den als Ausgangsmaterialien verwendeten metallisierten Basisplatten handelt es sich vor allem um durchkontaktierte, beidseitig metallkaschierte, vorzugsweise kupferkaschierte handelsübliche Plattenmaterialien. Die zur Kaschierung verwendeten Metallfolien, vorzugsweise Kupferfolien weisen ein galvanisch erzeugtes Treatment mit einer speziellen dendritischen Struktur auf, die beim Aufbringen auf den polymeren Trägerwerkstoff für die Erzeugung der speziellen Oberflächenbeschaffenheit der Basismaterialien maßgeblich verantwortlich ist.

Die Ausbildung der dendritischen Struktur kann dadurch gefördert werden, daß man den Galvanisierungsbädern Komplexbildner auf der Basis von Cadmium, Selen und Tellur zusetzt oder nachträglich die Elektrolytfolie auf chemisch oder mechanischem Wege aufrauht.

Besonders geeignet ist Basismaterial, das ein- oder beidseitig mit einer Metall- oder Kunststoff-Folie kaschiert ist, die auf der dem Basismaterial zugewandten Seite ein "Metall-Treatment" aufweist und durch mechanisches oder chemisches Entfernen der Folie von dem Folienmaterial befreit ist, wobei das Metall-Treatment haftfest auf dem Basismaterial verbleibt.

Zur Ablösung der Metallkaschierung sind wohl saure als auch neutrale und alkalische Redoxbäder geeignet. Beispielsweise seien salz- oder schwefelsäurehaltige Redoxsysteme auf Basis von $H_2O_2$, $ClO_3^{\ominus}$ und $Fe^{3+}$ sowie ammoniakalkalische natriumchlorit- und ammoniumpersulfathaltige Redoxsysteme erwähnt.

Die zur Aktivierung eingesetzten Aktivatoren sind organische Edelmetallverbindungen aus der Reihe Pt, Pd, Au, Ag, Ru und/oder Rh. In diesem Rahmen kommen sowohl ionische oder kolloidale Aktivatorsysteme in Betracht als auch Komplexverbindungen dieser Edelmetalle mit organischen Liganden.

Geeignete anorganische Aktivatoren sind Verbindungen der Elemente der ersten und achten Nebengruppe des periodischen Systems der Elemente und zwar

a) Verbindungen der Formel

$$Me^n \; E^m \; Hal_z^-$$

worin Me für Wasserstoff-, Alkali- oder Erdalkaliatome bzw. Schwermetallatome (Fe, Co, Ni oder Cu) oder für $NH_4$, Hal für Halogen (vorzugsweise Cl und Br) und E für ein Edelmetallatom der 1. oder 8. Nebengruppe des Periodensystems (vorzugsweise Pt, Pd und Au) mit der Wertigkeit m bzw. n und der Koordinationszahl z steht, wobei $z - m = n$ ist, oder

b) nichtkomplexe Salze dieser Elemente der Formel

$$E^m \; Hal_p^\ominus$$

Bevorzugt anzuwendende Edelmetallverbindungen sind solche der Formel $H_2PdCl_4$, $Na_2(PdCl_2Br_2)$, $Na_2PdCl_4$, $CaPdCl_4$, $Na_4(PtCl_6)$, $AgNO_3$, $HAuCl_4$, $CuCl_2$ und $CuCl$. Bevorzugt sind die Pd-Verbindungen.

Andere anorganische Aktivatoren sind kolloidale Systeme von metallischem Pd, Pt, Au und Ag, die gegebenenfalls darüber hinaus hydrolysierbare Verbindungen von Elementen der 3. und 4. Haupt- und Nebengruppen des Periodensystems (z. B. Si, Ti, Ta, Zn, Sn, Zr und Al) enthalten können.

Solche Aktivierungssysteme sind z. T. im Fachhandel erhältlich und im übrigen vielfach in der Literatur beschrieben.

Bevorzugt sind Pd- und Pd/Sn-Systeme.

Bei den erfindungsgemäß zu verwendenden organischen Aktivatoren handelt es sich um an sich bekannte Edelmetallverbindungen, beispielsweise um Pd- und Pt-Komplexe von Dienen, polymeren Komplexbildnern und α,ß-ungesättigten Ketonen, wie sie z. B. in DE-A 30 25 307, 31 50 985 und 33 24 767 beschrieben sind.

Bevorzugt sind organometallische Verbindungen, vorzugsweise -Komplexverbindungen, die außer der zur Metallbindung erforderlichen Gruppe wenigstens eine weitere funktionelle Gruppe aufweisen. Solche Verbindungen sind bekannt und in DE-A 3 148 280 beschrieben.

Weitere geeignete Aktivatoren sind solche Edelmetallkomplexverbindungen, in denen die Liganden und die zu komplexierenden Ionen bzw. Moleküle in einer "Gast/Wirt"-Wechselbeziehung stehen.

Als selektive Komplexliganden kommen cyclische oder acyclische Verbindungen in Frage, die wegen ihrer chemischen und/oder physikalischen Beschaffenheit ein Wirtsmolekül sind oder in Gegenwart von zu komplexierenden Ionogenen oder neutralen Verbindungen die zur Komplex-bzw. Adduktbildung erforderliche Form annehmen, wobei die polaren Bereiche in Gegenwart des zu komplexierenden Mediums zu diesem hinausgerichtet werden. Derartige Aktivatoren sind z. B. in US 4 661 384 beschrieben.

Die für die Sensibilisierung geeigneten Reduktionsmittel sind: Aminoborane, Alkalihypophosphite, Alkylborhydride, Hydrazinhydrat und Formalin.

Die Behandlung der Basisplatten mit den Lösungen oder Dispersionen von Aktivatoren und gegebenenfalls Sensibilisatoren kann durch Tauchen, Besprühen, Bedrucken, Tränken oder Imprägnieren erfolgen.

Eine weitere Ausführungsform der Aktivierung besteht darin, daß die Reduktion im Metallisierungsbad gleich mit dem Reduktionsmittel der stromlosen Metallisierung durchgeführt wird.

Um die Haftung der Metallauflage an der Trägeroberfläche zu erhöhen, werden solche Lösungsmittel oder Lösungsmittelgemische für die Aktivatoren bevorzugt eingesetzt, die zu einer geringen Anlösung oder Anquellung der zu metallisierenden Kunststoffoberfläche führen.

Die Aktivatoren können in Konzentrationsbereichen von 0,001 g/l (bezogen auf das Edelmetall) bis hin zur jeweiligen Löslichkeitsgrenze eingesetzt werden. Vorzugsweise arbeitet man mit 0,1 bis 3,0 g/l dieser Substanzen.

Die stromlose Abscheidung der ersten Metallschicht auf dem Basismaterial erfolgt nach in der Galvanotechnik üblichen Methoden.

Bevorzugte Schichtdicken sind 0,1 - 1,0 µm. Die Abscheidungsrate soll 5 - 25, vorzugsweise 10 - 15 µm/h betragen.

Diese Forderung wird durch im Handel erhältliche schnellabscheidende Natriumhypophosphit-haltige Bäder erreicht.

Bevorzugt sind hypophosphithaltige Vernickelungsbäder.

Die darauf abzuscheidende Kupferschicht in einer Dicke von 0,5 bis 5,0 µm erfolgt ebenfalls nach üblichen Methoden entweder stromlos, d.h. in einem chemischen Kupferbad (Korbtechnik) oder aber galvano-chemisch (Gestelltechnik).

Der Aufbau des Leiterbildes erfolgt nach der bekannten Semiadditiv-Differenzätzmethode, d. h. die mit der dünnen Metallauflage aus vorzugsweise Nickel und der Kupferauflage beschichtete Basisplatte wird nach Aufbringen einer Maske mit einer zweiten Metallschicht aus vorzugsweise Kupfer (für spezielle Zwecke auch Gold) chemisch oder vorzugsweise galvanisch versehen.

Die Schichtdicke dieser Metallauflage beträgt 20 - 70, vorzugsweise 40 - 45 µm.

Nach Entfernung der Maske wird die freiliegende Nickel-/Kupferschicht in üblichen Ätzbädern beseitigt (Differenzätzprozeß).

Die Maskierung erfolgt ebenfalls nach an sich bekannten Techniken, beispielsweise durch Aufdrucken von UV-härtenden Lacken, Auflegen von Siebdruckmasken oder UV-härtenden Folien.

Die Beseitigung der Masken erfolgt mechanisch durch Abziehen oder durch Weglösen in geeigneten Lösungsmitteln.

Um gegebenenfalls die Haftung der auf dem Träger abgeschiedenen Metallauflage zu erhöhen bzw. um eine hohe Prozeßsicherheit zu gewährleisten, kann eine Temperung nach der chemischen Verkupferung vorgenommen werden. Bemerkenswert ist, daß die Temperung überraschenderweise im Gegensatz zu den anderen Verfahren (s. beispielsweise DE-A 32 42 162 und US 4 327 126) an bereits endgehärteten Platten vorgenommen wird, was das Verfahren universell anwendbar, d. h. von der Lagerzeit des Trägermaterials unabhängig macht.

Die Temperungstemperatur kann im breiten Bereich von 50°C bis zum jeweiligen Zersetzungsbereich des polymeren Basismaterials variiert werden. Bevorzugt sind Temperaturen von 120-150°C. Die Temperungszeiten können zwischen 5 Minuten bis 10 Stunden variiert werden, wobei die Zeiten von 10 bis 60 Minuten besonders zu bevorzugen sind. Um einen Abbau des Basismaterials zu vermeiden, kann die Temperung unter Inertgas vorgenommen werden.

Bevorzugte Materialien zur Herstellung der Basisplatten sind wärmhärtbare oder duroplastische Kunststoffe (englisch: thermosetting resins) wie Phenol-, Epoxid-, Melamin- und Polyesterharze, wobei die Phenol- bzw. Epoxidharze in den Normgrößen FR-2, FR-3, FR-4 und FR-5 ganz besonders bevorzugt eingesetzt werden.

Die duroplastischen Substrate können mit Verstärkungsmaterialien, wie mit Glas-, Mineral-, Kohle- und Aramid-Fasern bzw. -Matten und deren Gemische untereinander, verstärkt werden.

Nach dem erfindungsgemäßen Verfahren werden gute Haftfestigkeiten der Metallauflagen auf den Basismaterialien erzielt. Die Abzugsfestigkeit der Metallauflagen nach DIN 53 494 betragen mindestens 40 N/25 mm, in der Regel jedoch zwischen 45 und 50 N/25 mm.

Nach dem erfindungsgemäßen Verfahren lassen ein- oder mehrlagige gedruckte Schaltungen verschiedenster Art herstellen. Besonders bevorzugt werden zweilagige durchkontaktierte Leiterplatten hergestellt.

Besonders hervorzuheben ist, daß das neue Verfahren die praktisch ausschußfreie Herstellung von Feinstleiterplatten mit Bahnbreiten von weniger als 100 $\mu$m ermöglicht.

Das Verfahren wird anhand der folgenden Beispiele näher erläutert.

Beispiel 1

Eine handelsübliche beidseitig kupferbeschichtete, glasmattenverstärkte Epoxidharzplatte (FR-4) wird durch Abätzen in einer alkalischen 15,7 %igen Natriumchloritlösung (pH ~ 12) von der Cu-Auflage befreit, in 2 %iger NaHSO₃-Lösung entgiftet, mit H₂O und dann mit Methanol gewaschen, getrocknet. Man erhält eine an der Oberfläche poröse Platte mit einem flächenbezogenen spezifischen Gesamtporenvolumen von 0,028 dm³/m² und einem mittleren Porendurchmesser von 2,0 $\mu$m bzw. einer mittleren Porentiefe von 2,5 $\mu$m. Sie wird anschließend 5 Minuten in einer Lösung bestehend aus 1,58 g 4-Cyclohexen-1,2-dica

rbonsäureanhydrid-palladium-II-chlorid, 1.500 ml nachgereinigtem CH₂Cl₂ und 2,15 g Titansäuretetrabutylester aktiviert, dann getrocknet und in einer Lösung bestehend aus 750 ml H₂O$_{dest.}$, 7,5 g Dimethylaminboran und 1,75 g NaOH (fest) sensibilisiert, und in einem handelsüblichen hypophosphithaltigen Vernickelungsbad 100 Sekunden vernickelt, wobei eine Nickelschicht von etwa 0,2 $\mu$m Dicke abgeschieden wird. Danach wird in einem ebenfalls käuflichen chemischen Kupferbad eine 2 $\mu$m dicke Kupferschicht aufgebracht, mit H₂O$_{dest.}$ gewaschen, im Trockenschrank bei 150°C getempert. Die so mit einer gut haftenden, elektrisch leitenden Metallauflage von ca. 2,2 $\mu$m versehene Probe wird mit Hilfe des Siebdruckverfahrens mit eine Galvanoresist in Form von Streifen, die 25 mm breit sind und ebenso 25 mm Abstand von einander aufweisen, bedeckt und dann die freie Metalloberfläche mit galvanischem Kupfer auf ca. 45 $\mu$m ver stärkt. Nun wird der Probekörper in Methylethylketon von der Maske befreit und die darunter liegende auf chemischem Wege abgeschiedene Cu-Auflage in einer Lösung aus 500 ml H₂O$_{dest.}$, 8,5 ml HCl (reinst 37 %ig) und 18,5 ml H₂O₂ abgeätzt (Differenzätzprozeß).

Man erhält eine Leiterplatte mit 150 $\mu$m breiten und ca. 40 $\mu$m starken Bahnen. Die Haftfestigkeiten der Kupferbahnen wurde nach DIN 53 494 bestimmt. Es wurde eine Haftfestigkeit von 46 N/25 mm gemessen.

Vergleichsbeispiel:

Verfährt man wie im obigen Beispiel beschrieben, bringt aber nach der Aktivierung und Sensibilisierung auf der Basisplatte keine dünne Nickelschicht auf, sondern scheidet in einem chemischen Kupferbad eine ca. 2,0 $\mu$m dicke Kupferschicht ab, verstärkt diese galvanisch und folgt dem Verfahrensablauf wie oben angegeben, so mißt man letztendlich eine Haftkraft der Kupferbahnen auf dem Basismaterial von nur 35 N/25 mm.

Beispiel 2

Eine in Europa-Format zurechtgeschnittene beidseitig Cu-kaschierte Epoxidharzplatte aus FR-4-Material wird in einer Redox-Lösung, bestehend aus 50 ml HCl (37 %ig), 60 ml H₂O₂ und 500 ml H₂O, von der Cu-Auflage befreit, Man bekommt eine oberflächenporöse Platte mit einem flächenbezogenen spezifischen Gesamtporenvolumen von 0,024 dm³/cm² und einem mittleren Porendurchmesser von 2,5 $\mu$m bzw. einer maximalen Porentiefe von 3,0 $\mu$m. Diese Platte wird in einer Lösung, bestehend aus 200 ml Aceton, 800 ml H₂O$_{dest.}$ und 0,8 g Mesityloxidpalladiumchlorid, im Verlaufe von 3 Minuten aktiviert. Danach wird die Platte 5 Minuten in einer Lösung von 5 g Dimethylaminboran in einem 1 l $H_2O$/Methanol-Gemisch (50 : 50 Vol.-%) behandelt. Nach kurzem Spülen wird in einem handelsüblichen hypophosphithaltigen Nickelbad, das ca. 6 $\mu$m Nickel/Stunde abscheidet, in ca. 1 1/2 minuten eine ca. 0,15 $\mu$m dicke Nickelschicht aufgebracht, Danach wird in einem handeldüblichen chemischen Kupferbad 3 $\mu$m Kupfer abgeschieden, mit Wasser gewaschen und im Trockenschrank bei 160° C getempert. Der weitere Verfahrensablauf erfolgt wie im Vergleichsbeispiel beschrieben. Die nach DIN 53 494 gemessene Haftfestigkeit der 40 $\mu$m dicken Kupferbahnen beträgt 45 N/25 mm.

Zu einem ähnlichen Ergebnis gelangt man, wenn man an Stelle der FR-4-Platte eine FR-2-Platte verwendet.

Beispiel 3

Eine beidseitig kupferbeschichtete, glasmattenverstärkte Epoxidharzplatte (FR-4) wird gebohrt und dann entstaubt. Diese Platte wird durch Abätzen in einer alkalischen 15,7 %igen Natriumchloridlösung (pH ~ 12) von der Cu-Auflage befreit, in 2 %iger $NaHSO_3$-Lösung entgiftet, mit $H_2O$ und Methanol gewaschen und getrocknet. Man erhält eine an der Oberfläche poröse Platte mit einem flächenbezogenen spezifischen Gesamtporenvolumen von 0,024 $dm^3/m^2$. Sie wird anschließend 5 Minuten in einer Lösung bestehend aus 1,2 g $Na_2PdCl_4$ - (reinst), 1 l nachgereinigtem Methanol und 2,15 g Titansäuretetrabutylester aktiviert, getrocknet und dann in einer Lösung, bestehend aus 750 ml $H_2O_{dest.}$, 7,5 g Dimethylaminboran und 1,75 g NaOH (fest) sensibilisiert, in einem handelsüblichen hypophosphithaltigen Nickelbad mit einer 0,1 $\mu$m dicken Nickelschicht versehen, darauf in einem formalinhaltigen Verkupferungsbad bis auf ca. 2 $\mu$m Dicke verkupfert, mit $H_2O_{dest.}$ gewaschen, im Trockenschrank bei 150° C getempert. Die so mit einer gut haftenden, elektrisch leitenden Metallauflage versehene Probe wird mit einer Siebdruckmaske auf der Basis von Polybutadien, welche freie rasterförmige Bahnen von etwa 100 $\mu$m aufweist, bedeckt und dann die freie Metalloberfläche mit galvanischem Kupfer auf ~ 45 $\mu$m verstärkt. Nun wird der Probekörper in Methylethylketon von der Maske befreit und die darunterliegende auf chemischem Wege abgeschiedene Cu-Auflage in einer Lösung aus 500 ml $H_2O_{dest.}$, 8,5 ml HCl (reinst 37 %ig) und 18,5 ml $H_2O_2$ abgeätzt (Differenzätzen). Man erhält eine durchkontaktierte, elektrische Leiterplatte mit ca. 100 $\mu$m breiten und ca. 40 $\mu$m starken Leiterbahnen. Die Metallauflage haftet an der Substratoberfläche außerordentlich gut. Sie läßt sich nach herkömmlichen Methoden löten. Der Querschnitt der auf diese Weise hergesstellten Leiterbahnen zeigt ein rechteckiges Profil.

Beispiel 4

Man verfährt wie in Beispiel 1, verwendet jedoch an Stelle des Nickelbades ein wäßriges Bad der folgenden Zusammensetzung:
35 g/l Nickelsulfat
50 g/l Eisen-(II)-ammoniumsulfat
75 g/l Kaliumtartrat
25 g/l Natriumhypophosphit
Ammoniak bis pH 9.2
Rest: Wasser
Die Verweilzeit der Platte im Bad bei 25° C beträgt 5 Minuten. Dabei scheidet sich eine Ni/Fe-Schicht ab, die 12 % Fe enthält.

Die Abzugsfestigkeit der darauf abgeschiedenen Kupferschicht beträgt 47 N/25 mm.

Beispiel 5

Man verfährt wie in Beispiel 1, verwendet jedoch ein Kobaltbad folgender Zusammensetzung:
50 g/l $CoCl_2$ • 6 $H_2O$
20 g/l $NaH_2PO_2$ • $H_2O$
100 g/l Weinsäure
10 g/l $H_3PO_3$
Natronlauge bis pH 8,5
Rest: Wasser
Die Verweilzeit bei 40° C beträgt 3 1/2 Minuten.

Nach der Verkupferung bildet sich eine Kupferauflage mit einer Abzugsfestigkeit von 43 N/25 mm.

Beispiel 6

Man verfährt wie in Beispiel 1, verwendet jedoch an Stelle des Nickelbades ein Bad folgender Zusammensetzung:
30 g/l $CoCl_2$ • 6 $H_2O$
30 g/l $NiCl_2$ • 6 $H_2O$
20 g/l $NaH_2PO_2$ • $H_2O$
100 g/l Kaliumnatriumtartrat
50 g/l $NH_4Cl$
Ammoniak bis pH 8,5
Rest: Wasser
Die Verweilzeit bei 90° C beträgt 2 Minuten.

Die Abzugsfestigkeit des auf der so gebildeten Ni/Co-Schicht abgeschiedenen Kupferauflage ist 46 N/25 mm.

Beispiel 7

Eine handelsübliche einseitig kupferbeschichtete Polyimidfolie wird durch Abätzen in einer alkalischen 15,7 %igen Natriumchloritlösung (pH - 12) von der Cu-Auflage befreit, mit $H_2O$ und dann mit Methanol gewaschen und getrocknet. Man erhält eine an der Oberfläche poröse Folie mit einem flächenbezogenen spezifischen Gesamtporenvolumen von 0,025 $dm^3$ /$m^2$ und einem mittleren Porendurchmesser von 2,0 $\mu$m bzw. einer mittleren Porentiefe von 2,5 $\mu$m. Diese Folie wird anschließend fünf Minuten in einer Lösung, bestehend aus 0,5 g n-3-Hepten-2-on-palladiumchlorid und 1.000 ml 1,1,1,-Trichlorethan, aktiviert, getrocknet und dann in einer Lösung, bestehend aus 750 ml $H_2O_{dest.}$, 7,5 g Dimethylaminboran 1,75 g NaOH (fest), sensibilisiert, in einem handelsüblichen hypophosphithaltigen Nickelbad vernickelt, danach in einem chemischen Kupferbad mit einer ca. 2 $\mu$m dicken Kupferschicht versehen, mit Wasser gewaschen und im Trockenschrank eine Stunde lang bei 170° C getempert. Die so mit einer Nickel- und Kupferauflage versehene Probe wird mit Hilfe des Siebdruckverfahrens mit einem Lack auf Basis von Polybutadien beschichtet, wobei freie rasterförmige Bahnen von etwa 200 $\mu$m ausgespart bleiben, und dann die freie Metalloberfläche mit galvanischem Kupfer auf ca. 35 $\mu$m verstärkt. Nun wird die Folie in Methylethylketon von der Maske befreit und die darunter liegende auf chemischem Wege abgeschiedene Nickel/Kupferauflage in einer schwefelsauren, $H_2O_2$ enthaltenden Lösung abgeätzt. Man erhält eine elektrische Schaltung mit ca. 200 $\mu$m breiten und ca. 32 $\mu$m starken Leiterbahnen.

**Ansprüche**

1. Verfahren zur Herstellung von zweilagigen, durchkontaktierten elektrischen Leiterplatten, dadurch gekennzeichnet, daß man Basisplatten, die beidseitig mit Cu-Folien kaschiert sind,

a) nach dem Zuschneiden und Bohren chemisch oder mechanisch von der Kupferkaschierung befreit,

b) die Oberflächen der Basisplatten und die Bohrlochwandungen durch Eintauchen in ein Aktivatorbad aktiviert

c) gegebenenfalls sensibilisiert,

d) in einem stromlosen Metallisierungsbad mit einer 0,05 - 2,0 $\mu$m starken Schicht aus Nickel, Kobalt, Mangan, einem Nickel/Eisen-oder Nickel/Kobalt-Gemisch versieht,

e) in einem darauffolgenden Kupferbad mit einer 0,05-5,0 $\mu$m starken Kupferschicht versieht und

f) darauf nach üblichen Semiadditivmethoden das Leiterbild aufbaut.

2. Verfahren nach Anspruch 1, dadurch gekennzeichnet, daß die Oberfläche der Basisplatten nach Entfernung der Metallkaschierung charakterisiert ist durch ein flächenbezogenes spezifisches Gesamtporenvolumen von 0,015 bis 0,045 $dm^3$ /$m^2$, einen mittleren Porendurchmesser von 0,05 bis 12,0 $\mu$m und eine mittlere Porentiefe von 0,05 bis 4,0 $\mu$m.

3. Verfahren nach den Ansprüchen 1 und 2, dadurch gekennzeichnet, daß die Aktivierung mit organischen Edelmetallkomplexverbindungen durchgeführt wird.

4. Verfahren nach Anspruch 1, dadurch gekennzeichnet, daß als Aktivatoren anorganische ionische oder kolloidale Aktivatorsysteme verwendet werden.

5. Verfahren nach Anspruch 1, dadurch gekennzeichnet, daß die Metallschicht aus Ni, Co, Mn oder Ni/Co eine Stärke von 0,1 - 1,0 $\mu$m aufweist.

6. Verfahren nach Anspruch 1, dadurch gekennzeichnet, daß die gemäß 1d) aufgebrachte Metallschicht eine Nickelschicht ist.

7. Verfahren nach Anspruch 1, dadurch gekennzeichnet, daß die gemäß 1e) aufgebrachte Kupferschicht stromlos oder elektrochemisch abgeschieden worden ist und eine Stärke von 1,0 bis 3,0 $\mu$m aufweist.

8. Verfahren nach Anspruch 1, dadurch gekennzeichnet, daß der Aufbau des Leiterbildes durch ein Semiadditiv-Differenzätzverfahren erfolgt.

9. Leiterplatten erhalten gemäß Anspruch 1.

10. Verwendung der Leiterplatten gemäß Anspruch 9 zur Herstellung von gedruckten Schaltungen.